# EUROPEAN PATENT APPLICATION

(11) **EP 4 557 348 A1**
(43) Date of publication of application: **21.05.2025**
(21) Application number: 23210371.3
(22) Date of filing: 16.11.2023
(51) Int. Cl.: H01L 21/3065

(54) **CYCLIC PROCESSING OF A SILICON NANOSTRUCTURE**

(71) Applicant: AlixLabs AB, 223 63 Lund (SE)
(72) Inventor: SUYATIN, Dmitry, 223 63 LUND (SE); SUNDQVIST, Jonas, 223 63 LUND (SE)
(74) Representative: Zacco Sweden AB

(57) **Abstract**

A method for processing a silicon nanostructure having a main surface delimited by, in relation to the main surface, inclined surfaces is presented. The method comprises subjecting the silicon nanostructure for a first cyclic process. Each cycle of the first cyclic process comprises: oxidizing the main surface and the inclined surfaces forming a silicon oxide layer on the main surface and the inclined surfaces; applying a first etching process configured to anisotropically etch the silicon oxide layer from the main surface while preserving the silicon oxide layer on the inclined surfaces, thereby exposing the silicon of the silicon nanostructure; and applying a second etching process configured to selectively etch the exposed silicon of the silicon nanostructure using the silicon oxide layers of the inclined surfaces as masking layers. Whereby selective etching of the main surface relative to the inclined surfaces is achieved such that a recess in the silicon nanostructure is formed, the recess having its opening at the main surface of the silicon nanostructure.

## Description

### TECHNICAL FIELD

The present invention relates to formation of nanostructures.

### BACKGROUND ART

The interest in manufacturing devices, e.g. advanced semiconductor devices, having dimensions below 100 nm is constantly growing. Today a lateral size of advanced semiconductor devices, i.e. electronic components such as transistors, is already at and even below 20 nm. However, fabrication of structures with lateral size below 20 nm is hard to achieve with present processes. For instance, the spatial resolution of ultraviolet lithography, UVL, which is commonly used for manufacturing semiconductor devices in industry, is limited. Therefore, alternative approaches are required to overcome such challenges and to allow fabrication of nanostructures with lateral size below 20 nm.

Therefore, a number of technologies are under development to allow fabrication of nanostructures with lateral size below 20 nm. Some examples are Extreme Ultra-Violet lithography, Self-Aligned Multi-Patterning, Electron-beam Direct-Write, Nano-Imprint Lithography, and Directed Self-Assembly.

Today, Extreme Ultra-Violet lithography is the most advanced direct patterning method in high volume manufacturing. However, Extreme Ultra-Violet lithography suffers from very thin resist layers, and it is usually difficult to achieve targeted line edge roughness (LER) and line width roughness (LEW) with this patterning technology. Self-aligned patterning is a complementary patterning technique that is widely used when the optical lithography cannot provide the resolution that is required. This self-aligned patterning also has some technical limitations and involves multiple processing steps, driving the associated patterning costs. Often, it has a limited yield and throughput.

In view of the above, there is room for improvement in fabrication of nanostructures, especially fabrication of nanostructures with lateral size below 20 nm.

### SUMMARY OF THE INVENTION

The present invention is set out in the appended set of claims.

A method for processing a silicon nanostructure having a main surface delimited by, in relation to the main surface, inclined surfaces is provided. The method comprises subjecting the silicon nanostructure for a first cyclic process. Each cycle of the first cyclic process comprises: oxidizing the main surface and the inclined surfaces forming a silicon oxide layer on the main surface and the inclined surfaces; applying a first etching process configured to anisotropically etch the silicon oxide layer from the main surface while preserving the silicon oxide layer on the inclined surfaces, thereby exposing the silicon of the silicon nanostructure; and applying a second etching process configured to selectively etch the exposed silicon of the silicon nanostructure using the silicon oxide layers of the inclined surfaces as masking layers. Whereby selective etching of the main surface relative to the inclined surfaces is achieved such that a recess in the silicon nanostructure is formed, the recess having its opening at the main surface of the silicon nanostructure. The first etching process and the second etching process are different etching processes.

According to the presented method for processing a silicon nanostructure, multiple separate processes as used in the prior art, are integrated into one process as different process steps. This provides for improved process control, reduces operating expenses (OPEX), and capital expenditures (Capex), while improving the throughput. Especially, the increased process control is provided by utilizing a cyclic processing where different processing effects dominate in different steps. Further, the process control and the multiple-step integration are enabled by introducing the first and second etching processes within each cycle in the cyclic processing. In the first and second etching processes, surface modification and etch processes are done differently. That is, with different process selectivity. Hence, by utilizing a cyclic processing, where different processes dominate in different steps of each cycle in the cyclic process, control is enabled so that a recess may be formed in the silicon nanostructure subjected for the cyclic processing. By the proposed cyclic processing, the number of process steps may be decreased as compared with the conventional processing of nanostructures. This facilitates an increase in the throughput and provides for making production more economical. The proposed process facilitates pushing of the resolution limits, this since the number of defects in the produced nanostructures may be reduced. The proposed processing method may even heal some imperfections of incoming structures. All this by relying on changes in already existing equipment and processes, saving time and resources for the industry.

The oxidizing may be performed using plasma.

The plasma in the oxidizing may be provided such that ions impinging the silicon nanostructure have a kinetic energy below 1 eV, preferably below 0.1 eV. This low ion energy provides that the oxide layer is uniform and has the same thickness on horizontal, inclined, and vertical surfaces in relation to the main plane of the sample surface, i.e., the isotropic oxidation process. Then, by applying an anisotropic etching process for this oxide layer, it is possible to selectively etch away the oxide layer from horizontal surfaces while keeping the oxide layer on inclined and vertical surfaces.

According to one embodiment, the first etching process may be performed by reactive ion etching with ions having a first kinetic energy upon impinging the silicon nanostructure. The ions in the reactive ion etching of the first etching process may be formed from ionized SF₆ gas contained in a gas mixture supplied to the process chamber volume. The second etching process may be performed by reactive ion etching with ions having a second kinetic energy upon impinging the silicon nanostructure. The ions in the reactive ion etching of the second etching process may be formed from ionized SF₆ gas contained in a gas mixture supplied to the process chamber volume. The second kinetic energy is lower than the first kinetic energy. Hence, reactive ion etching may be used for both the first and second etching processes, the kinetic energy of the ions being different for the two processes.

According to another embodiment, the first etching process may be performed by reactive ion etching and the second etching process may be a second cyclic etching process, where each cycle comprises surface modification by introducing chemical species in a process chamber volume enclosing the silicon nanostructure and surface activation by noble gas ion bombardment. Hence, a continuous etch process in the form of reactive ion etching may be used for the first etching process, and a cyclic etching process may be used for the second etching process. The reactive ion etching may be done using ionized SF₆ gas contained in a gas mixture supplied to the process chamber volume. In the second cyclic etching process the noble gas may be argon. The chemical species used in the surface modification of the second cyclic etching process may be halogens. The surface modification of the second cyclic etching process may be done in a gas phase that contains only neutral chemical species. More specifically, the surface modification of the second cyclic etching process may be done by chlorine chemisorption. The surface modification of the second cyclic etching process may be followed by an evacuation of excessive chemical species from the process chamber volume.

According to yet another embodiment, both the first and second etching processes may be cyclic etching processes both comprising surface modification and surface activation. The first etching process may be a third cyclic etching process, where each cycle comprises surface modification by introducing chemical species in a process chamber volume enclosing the silicon nanostructure and surface activation by noble gas ion bombardment having a third kinetic energy. The chemical species used in the surface modification of the third cyclic etching process may be halogens. The surface modification of the third cyclic etching process may be done in a gas phase that contains only neutral chemical species. More specifically, surface modification of the third cyclic etching process may be done by chlorine chemisorption. The surface modification of the third cyclic etching process may be followed by an evacuation of excessive chemical species from the process chamber volume. The second etching process may be a fourth cyclic etching process, where each cycle comprises surface modification by introducing chemical species in the process chamber volume and surface activation by noble gas ion bombardment having a fourth kinetic energy. The fourth kinetic energy is lower than the third kinetic energy. Hence, two different cyclic etching processes may be used for the first and second etching processes, the kinetic energy of the ions being different for the two processes. The chemical species used in the surface modification of the fourth cyclic etching process may be halogens. The surface modification of the fourth cyclic etching process may be done in a gas phase that contains only neutral chemical species. More specifically, surface modification of the fourth cyclic etching process may be done by chlorine chemisorption. The surface modification of the fourth cyclic etching process may be followed by an evacuation of excessive chemical species from the process chamber volume.

In the third and fourth cyclic etching processes the noble gas may be argon. The fourth kinetic energy may be an average kinetic energy of 40 eV to 60 eV. The third kinetic energy may be a kinetic energy in a range of 65 eV to 80 eV average kinetic energy.

According to a further embodiment, the first etching process may be performed by a fifth cyclic etching process comprising surface modification and surface activation and the second etching process may be a reactive ion etching process. The reactive ion etching may be done using ionized SF₆ gas contained in a gas mixture supplied to the process chamber volume. The fifth cyclic etching process comprises surface modification by introducing chemical species in a process chamber volume enclosing the silicon nanostructure, and surface activation achieved by noble gas ion bombardment. The noble gas may be argon. The chemical species used in the surface modification of the fifth cyclic etching process may be halogens. The surface modification of the fifth cyclic etching process may be done in a gas phase that contains only neutral species. More specifically, the surface modification of the fifth cyclic etching process may be done by chlorine chemisorption. The surface modification of the fifth cyclic etching process may be followed by an evacuation of excessive chemical species from the process chamber volume.

At least a portion, preferably each, of the cycles of the first cyclic process may further comprise purging a process chamber volume used for the processing of the silicon nanostructure by flushing the process chamber volume with a gas mixture, preferably containing oxygen. The flushing may be performed for 1-30 seconds at 0.01-100 mTorr, preferably 0.1-3 mTorr, process pressure, and at 10-200 sccm, preferably 30-50 sccm, oxygen flow.

The silicon nanostructure may be arranged on a support layer. The support layer may be silicon, silicon nitride, or silicon oxide.

The number of cycles in the first cyclic process may be in the range of 5 to 200 cycles.

### BRIEF DESCRIPTION OF THE DRAWINGS

The above and other aspects will now be described in more detail, with reference to appended figures. The figures should not be considered limiting; instead, they are used for explaining and understanding.

As illustrated in the figures, the sizes of layers and regions may be exaggerated for illustrative purposes and, thus, are provided to illustrate the general structures. Like reference numerals refer to like elements throughout.
Fig. 1 schematically illustrates a silicon nanostructure to be exposed to the processing disclosed herein.
Fig. 2 is a block diagram of a method for processing a silicon nanostructure.
Fig. 3, comprising Figs 3A-3G, schematically illustrates results after process steps in the method of Fig. 2.

### DETAILED DESCRIPTION

The present invention will now be described more fully hereinafter with reference to the accompanying drawings, in which currently preferred embodiments of the invention are shown. This invention may, however, be embodied in many different forms.

The present invention is directed towards a method for processing a silicon nanostructure. Especially, the present invention is directed towards selective etching of a main surface of the silicon nanostructure relative to inclined surfaces of the silicon nanostructure.

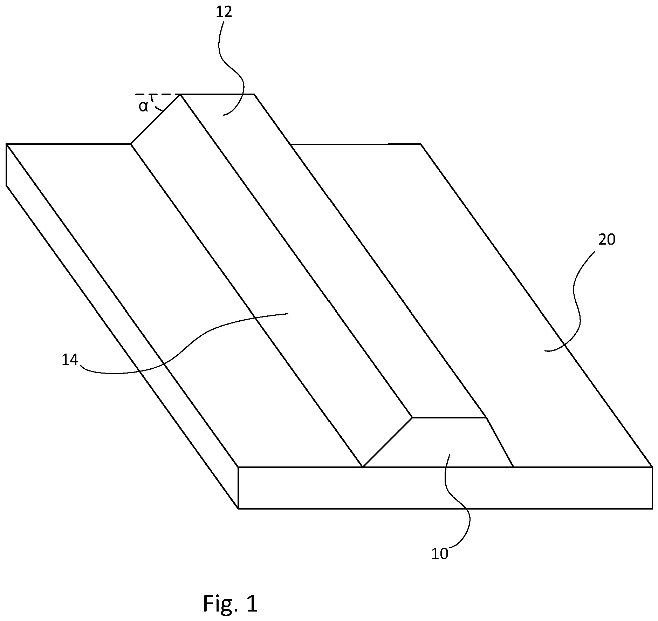

An example of a silicon nanostructure 10 to be exposed to the processing of the present invention is schematically illustrated in connection with Fig. 1. An inclination angle a for the inclined surfaces 14 in relation to the main surface 12 is in this example 60°. It is however to be realized that the processing of the silicon nanostructure as discussed herein may be made on silicon nanostructure having different geometries, this as long as the silicon nanostructure exhibits a main surface limited by inclined surfaces. The inclination angle α for the inclined surfaces 14 in relation to the main surface 12 is to be larger than 10°, preferably larger than 20°. Above an inclination angle of 60° was presented. However, other inclination angles may be used, such as 90°. Further, the inclination angle may be different for the different inclined surfaces of the silicon nanostructure.

The silicon nanostructure 10 is preferably arranged on a support layer 20. The support layer 100 may be formed of silicon, or silicon oxide, or silicon nitride. Other materials can also be utilized to form this support layer.

In Fig. 1 a single silicon nanostructure is illustrated, it is, however, to be understood that a plurality of silicon nanostructures may be exposed to the process of the present invention simultaneously. Such plurality of silicon nanostructures is preferably arranged on a same support layer 20. According to one example, such a plurality of silicon nanostructures is arranged in an array, preferably with a known pitch.

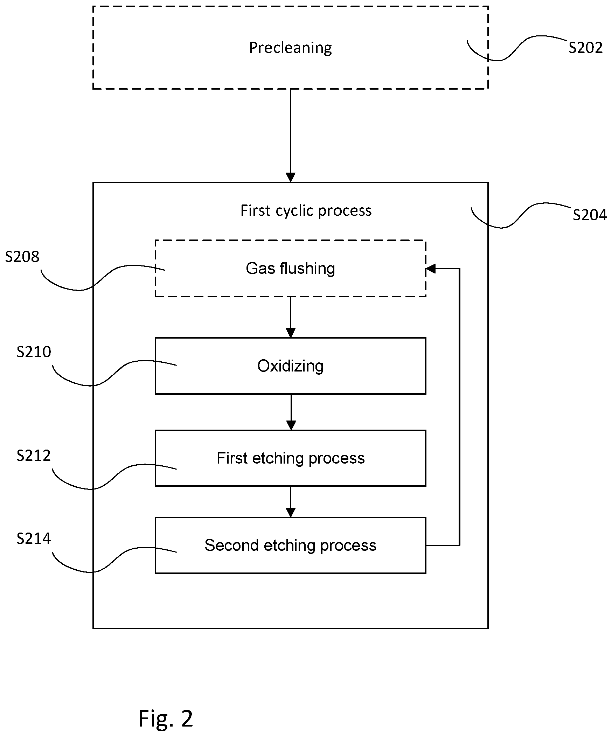

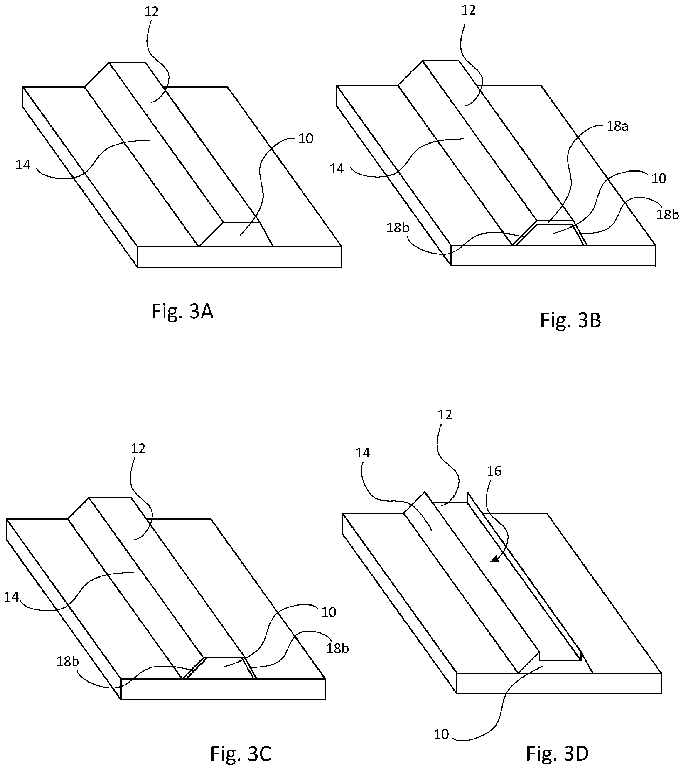

In connection with Fig. 2 and Figs 3A-G a method for processing a silicon nanostructure 10 will be discussed. The silicon nanostructure 10 having a main surface 12 delimited by, in relation to the main surface 12, inclined surfaces 14. Such a silicon nanostructure 10 arranged on a support layer 20 is illustrated in Fig 3A.

The method comprises subjecting the silicon nanostructure for a first cyclic process S204. A number of cycles in the first cyclic process S204 may vary depending on various factors such as a thickness of the silicon nanostructure 10, processing parameters of the process steps in the first cyclic process S204, and the type of process steps in the first cyclic process S204. Typically, the number of cycles in the first cyclic process S204 may vary in the range of 5 to 200 cycles.

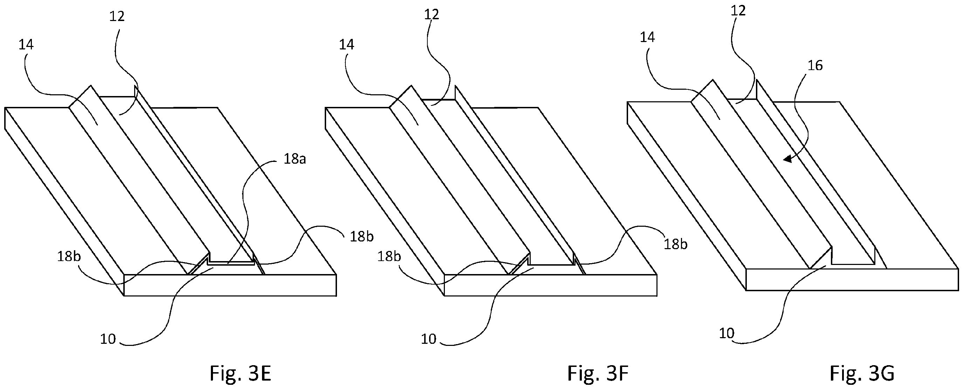

Each cycle of the first cyclic process S204 comprises oxidizing S210 the main surface 12 and the inclined surfaces 14 forming a silicon oxide layer 18a, 18b on the main surface 12 and the inclined surfaces 14. The result of a first such oxidation S210 step is illustrated in Fig. 3B. Each cycle of the first cyclic process S204 further comprises applying a first etching process S212 configured to anisotropically etch the silicon oxide layer 18a from the main surface 12 while at least partly preserving the silicon oxide layer 18b on the inclined surfaces 14, thereby exposing the silicon of the main surface 12 of the silicon nanostructure 10. The result after a first such first etching process S212 is illustrated in Fig. 3C. Here, it can be seen that the silicon oxide layer 18a of the main surface 12 has been etched away. Each cycle of the first cyclic process S204 further comprises applying a second etching process S214 configured to selectively etch the exposed silicon of the main surface 12 of the silicon nanostructure 10 using the silicon oxide layers 18b of the inclined surfaces 14 as masking layers. As a result, selective etching of the main surface 12 relative to the inclined surfaces 14 is achieved. This will form a recess 16 in the silicon nanostructure 10. The recess 16 having its opening at the main surface 12 of the silicon nanostructure 10. The result after a first such second etching process S214 is illustrated in connection with Fig. 3D. In Fig. 3D a recess 16 is formed at the main surface 12. Although the second etching process S214 is configured to selectively etch the exposed silicon of the main surface 12 of the silicon nanostructure 10 using the silicon oxide layers 18b of the inclined surfaces 14 as masking layers, the silicon oxide layers 18b of the inclined surfaces 14 will typically also be affected by the second etching process S214 and in the end be substantially etched away. This is what is illustrated in Fig 3D, where the silicon oxide layers 18b of the inclined surfaces 14 have disappeared. Once this has occurred, or, preferably, a little before that, while the silicon oxide layers 18b of the inclined surfaces are still uniformly covering the sidewalls 14 but this oxide layer is already very thin and at risk of being fractured by further processing, it is time to start a new cycle of the first cyclic process S204. A second cycle of the first cyclic process S204 is illustrated in connection with Figs 3E-G. As illustrated in Fig 3E a new silicon oxide layer 18a, 18b is formed on the main surface 12 and the inclined surfaces 14 by again oxidizing S210 the main surface 12 and the inclined surfaces 14. The result after applying another step of the first etching process S212 is illustrated in connecting with Fig 3F. Here, it is illustrated that the silicon oxide layer 18a of the main surface 12 again has been etched away. The result after applying another step of the second etching process S214 is illustrated in connecting with Fig 3G. Here it is illustrated that the recess 16 is even deeper than before.

Hence, the present processing of a silicon nanostructure 10 provides selective etching such that a recess 16 in the silicon nanostructure 10 is formed. The recess 16 having its opening at the main surface 12 of the silicon nanostructure 10.

Upon the silicon nanostructure 10 being an elongated structure, the recess 16 may form a channel in the elongated silicon nanostructure. However, by continuing the first cyclic processing S204 with additional cycles, the recess 16 may form a through hole in the elongated silicon nanostructure 10, splitting the elongated silicon nanostructure 10 in two.

Applying the first etching process S212 is performed after, preferably directly after, the oxidizing S210. Applying the second etching process S214 is performed after, preferably directly after, applying the first etching process S212.

The oxidizing S210 may be performed using plasma. The plasma may be provided in such a way that ions impinging the silicon nanostructure 10 have energy below 1 eV, preferably below 0.1 eV. The plasma assisting the oxidation process may be generated in a gas mixture containing oxygen. As an example, the plasma may be generated using 13,56 MHz or 2 MHz and 0.1-3000W, preferably 1000-2000 W, radiofrequency power inductively or transformer coupled to the processing chamber in which the processing of the silicon nanostructure is performed. The oxidizing may be performed for 1-300 seconds, preferably 5-20 seconds, at 0.01-2000 mTorr, preferably 30-100 mTorr, process pressure, and 10-200 sccm, preferably 30-50 sccm, oxygen flow and no additional gasses in the process chamber volume.

The first cyclic process S204 can be performed in any specialized plasma etch system. Examples of equipment manufacturers include Lam Research, Applied Materials, Tokyo Electron (TEL), Oxford Instruments Plasma Technology (OIPT), and Plasma-Therm. Specifically, this process can be performed in the Plasmalab 100 ICP-RIE system from OIPT, or the Takachi ICP-RIE system from Plasma-Therm, or 2300 Kiyo plasma etch system with a transformer coupled plasma source from Lam Research.

In the beginning of a cycle, preferably each cycle, of the first cyclic process S204, the processing chamber is flushed S208 with a gas. The gas is preferably oxygen. This purges any gases and reaction by-products that may have stayed in the chamber from previous steps. Such flushing S208 with gas of the processing chamber prepares the chamber and the equipment therein for the subsequent steps. Using oxygen gas, typical process parameters for flushing S208 with gas are: duration 1-30 seconds at 0.01-50 mTorr, preferably 0.1-3 mTorr, process pressure, with an oxygen flow of 10-200 sccm, preferably 30-50 sccm. As readily understood, these processing parameters depend on the process chamber volume. Preferably, no plasma is applied in the process chamber volume during the gas flushing S208.

Further, before starting the first cyclic process S204, the silicon nanostructure 10 and possibly also the support layer 20 it is arranged on, may be pre-cleaned. Hence, the method may comprise a step of preclearing S202. Such a pre-cleaning S202 may comprise exposing the silicon nanostructure 10 (and possibly also the support layer 20 it is arranged on) for a plasma or chemical treatment. This is in order to achieve a silicon nanostructure 10 (and possibly also a support layer 20 it is arranged on) which is free of contaminants and native oxides. For native oxide removal buffered oxide etch 10:1 can be performed by, for example, immersing the substrate into a buffered HF for 30 seconds, followed by 30 seconds of rinsing in deionized water and dry blow with N₂ for 15 seconds.

We will now discuss the first and second etching processes S212, S214 in more detail. First and foremost, the first etching process S212 and the second etching process S214 are different etching processes. Herein "different etching processes" means that at least one processing parameter in an etching process is altered transitioning from the first etching process S212 to the second etching process S214. Importantly to note is that the first etching process S212 is configured to anisotropically etch the silicon oxide layer 18a from the main surface 12 while preserving the silicon oxide layer 18b on the inclined surfaces 14 and that the second etching process S214 is configured to selectively etch exposed silicon of the silicon nanostructure 10 using the silicon oxide layers 18b of the inclined surfaces 14 as masking layers. Below a number of different scenarios of the first and second etching processes S212, S214 will be discussed.

According to a first example, reactive ion etching is used for both the first etching process S212 and the second etching process S214. However, the kinetic energy of the ions being different for the two processes, or the gas mixture being different for the two processes, or both. Reactive ion etching is a continuous etch mode. According to this first example, the first etching process S212 is performed by reactive ion etching using ions having a first kinetic energy upon impinging the silicon nanostructure 10 and the second etching process S214 is performed by reactive ion etching using ions having a second kinetic energy upon impinging the silicon nanostructure 10. The second kinetic energy is lower than the first kinetic energy. Preferably, the ions impinging the silicon nanostructure in the second etching process S214 have a kinetic energy below 1 eV, preferably below 0.1 eV. This ensures that the oxide layer remaining on the inclined and vertical surfaces is not etched significantly during this process and can act as an efficient etch mask for selectively etching silicon exposed on horizontal surfaces after the oxide layer is selectively removed from horizontal surfaces during the first etching process S212. The ion energy and directionality for the first etching process S212 must be significantly higher than for the second etching process S214. This ensures the directionality of the etching process (anisotropic etching) and, therefore, selective etching of the oxide layer from horizontal surfaces. At the same time, the ion energy for the first etching process should not be too high. This is to ensure that the oxide etch rate stays relatively small so that it is practically possible to stop the etch process when the oxide layer is completely etched from horizontal surfaces and while it still remains as a continuous film on inclined and vertical surfaces. It is important to stop the second etching process S214 before the silicon oxide layer(s) 18b on the inclined surface(s) 14 becomes discontinuous. Importantly, the ion energy must stay well below the physical sputtering threshold. This is because this physical sputtering is more efficient on inclined surfaces and will work against selective etching of the oxide layer from horizontal surfaces. The exact values will depend on the other process details, first of all, on the process gas mixture.

The ions in the reactive ion etching of the first etching process may be formed from ionized SF₆ gas contained in a gas mixture supplied to the process chamber volume. The ionization of the gas may be done using plasma generated by applying 13,56 MHz and 0.1-30 W, preferably 10-20 W, radiofrequency power to the electrode on which the silicon nanostructure is placed. The ions in the reactive ion etching of the second etching process may be formed from ionized SF₆ gas contained in a gas mixture supplied to the process chamber volume, The ionization of the gas may be done using plasma generated by applying 13,56 MHz or 2 MHz and 0.1-3000W, preferably 1000-2000 W, radiofrequency power inductively or transformer coupled to the processing chamber in which the processing of the silicon nanostructure is performed. According to this first example, typical process parameters for the first etching process S212 are: duration 0.1-300 seconds, preferably 3-30 seconds, at 0.01-20 mTorr, preferably 0.01-5 mTorr, process pressure, and 1-200 sccm, preferably 5-50 sccm, SF₆ gas flow. According to this first example, typical process parameters for the second etching process S214 are: duration 0.1-300 seconds, preferably 3-30 seconds, at 0.01-100 mTorr, preferably 1-50 mTorr, process pressure, and 1-200 sccm, preferably 5-50 sccm, SF₆ gas flow. The exact process parameters will depend on the process chamber design and processed sample size and geometry.

According to a second example, the first etching process S212 is performed using reactive ion etching and the second etching process S214 is performed using a second cyclic etching process, where each cycle comprises surface modification and surface activation. The reactive ion etching of the first etching process S212 may be performed using ionized SF₆ gas contained in a gas mixture supplied to the process chamber volume. After having completed the reactive ion etching of the first etching process S212 the silicon oxide layer 18a, 18b of the silicon nanostructure 10 has been anisotropically etched such that the silicon oxide layer 18a of the main surface 12 is etched away and the silicon oxide layer(s) 18b on the inclined surfaces 14 has been preserved. The cycles of the second cyclic etching process comprising a step of surface modification and a step of surface activation. The surface modification may be performed by introducing chemical species in the process chamber volume enclosing the silicon nanostructure. The chemical species may be halogens. The surface modification may be done in a gas phase that contains only neutral chemical species. More specifically, the surface modification may be made by the chemisorption of chlorine. The surface modification may be followed by an evacuation of excessive chemical species from the process chamber volume. The surface activation may be made by impinging the silicon nanostructure 10 with noble gas ions. Preferably, argon ions are used. Typically, an average kinetic energy of the argon ions impinging the silicon nanostructure 10 is set to be 40 eV to 60 eV at least in the case of plasma-assisted surface modification similar to the process previously reported by Samantha Tan et al. in "Highly Selective Directional Atomic Layer Etching of Silicon" ECS Journal of Solid State Science and Technology, 4 (6) N5010-N5012 (2015). A number of cycles of the second cyclic etching process in this example of the second etching process S214 depend on the process selectivity of etching silicon as compared to silicon oxide. According to experience, the selectivity of this process can be expected to be approximately 1:10 or better; hence, the cyclic process of the second etching process S214 is typically set to run for 10-30 cycles until the silicon oxide layer(s) 18b on the inclined surfaces is eroded. It is preferred to stop the second etching process S214 before the silicon oxide layer(s) 18b on the inclined surface(s) 14 becomes discontinuous. During the second etching process S214 silicon from the main surface 12 is etched away while preserving some oxide on inclined surface(s) 14. Typical process parameters for the second cyclic etching process of the second etching process S214 in this example are: 10-30 cycles, 0.1-300 seconds, preferably 0.5-30 seconds, for each step of the cyclic process, at 0.01-100 mTorr, preferably 0.01-60 mTorr, process pressure, 1-200 sccm, preferably 5-30 sccm, Cl₂ gas flow; and 1-200 sccm, preferably 5-30 sccm, Ar gas flow. The process pressure for the chlorination step is preferred to be 30-60 mTorr. This chlorination step is typically done without the application of any radiofrequency power to the electrode on which the silicon nanostructure is positioned. The radiofrequency power inductively or transformer coupled to the chamber is preferred to be in the range 500-1500 W, preferably 900-1100 W. The process pressure for the activation step with Ar bombardment is preferred to be 1-5 mTorr. This activation step is typically done with very small radiofrequency power applied to the electrode on which the silicon nanostructure is positioned. This power is usually adjusted to have the average Ar ion energy between 40 to 60 eV, typically corresponding to 0-20 W applied power. The radiofrequency power inductively or transformer coupled to the chamber during this step is preferred to be 100-500 W, preferably 200-200 W. The exact process parameters will depend on the process chamber design and processed sample size and geometry.

According to a third example, both the first etching process S212 and the second etching process S214 are performed as cyclic etching processes both comprising surface modification and surface activation. However, the kinetic energy of the ions used in the surface activation of the second etching process S214 is different from the kinetic energy of the ions used in the surface activation of the first etching process S212. In both the first etching process S212 and the second etching process S214 surface modification may be performed by introducing chemical species in the process chamber volume enclosing the silicon nanostructure. The chemical species may be halogens. Further, the surface modification may be done in a gas phase that contains only neutral chemical species. More specifically, the surface modification may be done by chemisorption of chlorine. During the surface modification Cl₂ is preferably dissociated into atomic species. Transformer-coupled plasma or inductively coupled plasma may be used for the surface modification, this without power application to the processed silicon structure 10. Typically, the surface modification using chlorine may be performed using a pressure of 60 mTorr, the source power may be 900 W, and the surface modification may be performed with a 2-second duration or preferably with 0.5-second duration. The surface activation in both the first etching process S212 and the second etching process S214 is made by impinging the silicon nanostructure 10 with noble gas ions. Preferably argon ions are used. Typically, a source power during the surface activation is set to be 300 W with a pressure of 5 mTorr and a duration of 2.5 seconds. Using argon ions with different kinetic energies, a good selectivity of etching silicon as compared with silicon oxide may be achieved. Experimental results, see e.g. Figs 3 and 4 as presented by Samantha Tan et al in "Highly Selective Directional Atomic Layer Etching of Silicon" ECS Journal of Solid State Science and Technology, 4 (6) N5010-N5012 (2015), have shown that silicon may be selectively etched as compared with silicon oxide using atomic layer etching as discussed above. Silicon can be selectively etched as compared with silicon oxide using 40 - 60 eV average kinetic energy of the argon ions. Hence, using argon ions having 40 - 60 eV average kinetic energy is preferred for the surface modification of the second etching process S214. On the other hand, in order to etch silicon oxide in the surface modification of the first etching process S212 a comparable higher average kinetic energy for the argon ions is needed. Using an average kinetic energy for the argon ions of 65-80 eV for surface activation after the surface modification of the first etching process S212 may be used. It is preferred to keep the average kinetic energy below 80 eV during the surface activation of the first etching process S212 to avoid high-speed sputtering of silicon oxide layer in this way enabling controlled etch stopping when the oxide layer 18a is selectively removed from horizontal surfaces on the main surface 12 and preserving oxide layer 18b on inclined and vertical surfaces. The surface modification of the cyclic etching processes in connection with the first etching process S212 and/or the second etching process S214 may be followed by an evacuation of excessive chemical species from the process chamber volume.

According to a fourth example, the first etching process S212 may be performed by a cyclic etching process comprising surface modification and surface activation and the second etching process S214 may be a reactive ion etching process. The reactive ion etching may be done using ionized SF₆ gas in a gas mixture supplied to the process chamber volume. Parameters for this reactive ion etching process may be the same as for the first etching process S212 provided in the first example described earlier. The surface modification of the cyclic etching process of the first etching process S212 may be performed by introducing chemical species in the process chamber volume enclosing the silicon nanostructure. The surface modification may be done in a gas phase that contains only neutral species. More specifically, the surface modification may be done by chlorine chemisorption. The surface modification of the cyclic etching process of the first etching process S212 may be followed by an evacuation of excessive chemical species from the process chamber volume. The surface activation of the cyclic etching process of the first etching process S212 may be achieved by noble gas ion bombardment. The noble gas may be argon. The process parameters for the cyclic process in this example may be the same as for the cyclic etch process S214 in the previous example.

The processing of a silicon nanostructure 10 according to the present invention may be used for assisting different lithographic and patterning techniques, including but not limited by deep ultraviolet lithography (DUV), extreme ultraviolet lithography (EUV), nanoimprint lithography (NIL), self-aligned multiple patterning (SAMP). This processing assists these techniques by splitting the pitch of structures made with these techniques, in this way providing a means to manufacture and even scale down different nanoscale devices in a cost-efficient way. This way, the process can be used for manufacturing of different nanoscale devices, which can also be produced with the other lithographic and patterning techniques. According to a non-limiting example, the processing may be used for recessing FinFET gate channels. According to another non-limiting example, the processing may be used for forming and/or modifying a transistor gate channel, such as a GAAFET nanowire gate channel.

The person skilled in the art realizes that the present invention by no means is limited to what is explicitly described above. On the contrary, many modifications and variations are possible within the scope of the appended claims.

For example, the surface modification and/or the surface activation of any one of the cyclic processes discussed above may include a self-limiting reaction that slows down or stops as a function of time or, equivalently, as a function of species dosage. Such a self-limiting reaction comprises chemisorption, deposition, extraction, and/or conversion such as oxidation or nitridation.

The method for processing a silicon nanostructure may further comprise an additional passivation step preceding the oxidation step. Such a passivation step prevents silicon surface oxidation and allows at the same time to oxidize other surfaces.

Upon executing the method for processing a silicon nanostructure, process control information may be monitored by e.g. optical emission and residual gas analysis. Process parameters of the method may then be adjusted based on the process control information.

The method for processing a silicon nanostructure may be repeated until the processing has no further effect on the nanostructure.

In connection with the evacuation of excessive chemical species from the process chamber volume discussed above for the various embodiments/examples this may be performed by alternating pumping the process chamber to low pressure and flashing the process chamber with a gas at a relatively high pressure. This alternation may be done several times to assist in the fast removal of the species remaining in the process chamber. The pumping is preferably done to a chamber pressure below 0.1 mTorr. The purging is preferably made by an inert gas or an inert gas containing gas mixture. As an option, the purging may comprise hydrogen, which removes excessive oxygen from the process chamber. The chamber pressure during the purging is preferably above 10 mTorr, more preferably above 50 mTorr. The optimal purging pressure depends on the pumping ability of the specific etch system.

The oxidizing S210 and the first etching process S212 may be separated with a step for evacuation of excessive oxygen from the process chamber volume. This may be performed by alternating pumping the chamber to low pressure and purging the process chamber with a gas or a gas mixture. This alternation may be done several times to assist in the fast removal of the species remaining in the process chamber. The pumping is preferably done to a chamber pressure below 0.1 mTorr. The purging is preferably made by an inert gas or an inert gas containing gas mixture. As an option, the purging may comprise hydrogen, which removes excessive oxygen from the process chamber. The chamber pressure during the gas purge is preferably above 10 mTorr, more preferably above 50 mTorr. The optimal purging pressure depends on the pumping ability of the specific etch system.

It is further realized that by exposing a silicon nanostructure which is not elongated but has a substantially square extension exhibiting a substantially planar top surface limited by inclined surfaces, a box structure may be formed. Also, silicon nanostructures that exhibit a circular, a triangular, or having any geometric shape top surface may be processed using the herein disclosed processing of a silicon nanostructure.

Additionally, variations can be understood and effected by the skilled person in practicing the claimed invention, from a study of the drawings, the disclosure, and the appended claims.

## Claims

1. A method for processing a silicon nanostructure (10) having a main surface (12) delimited by, in relation to the main surface (12), inclined surfaces (14), the method comprising:
subjecting the silicon nanostructure (10) for a first cyclic process (S204) where each cycle comprises:
oxidizing (S210) the main surface (12) and the inclined surfaces (14) forming a silicon oxide layer (18a, 18b) on the main surface (12) and the inclined surfaces (14);
applying a first etching process (S212) configured to anisotropically etch the silicon oxide layer (18a) from the main surface (12) while preserving the silicon oxide layer (18b) on the inclined surfaces (14), thereby exposing the silicon of the silicon nanostructure (10); and
applying a second etching process (S214) configured to selectively etch the exposed silicon of the silicon nanostructure (10) using the silicon oxide layers (18b) of the inclined surfaces (14) as masking layers;
wherein the first etching process (S212) and the second etching process (S214) are different etching processes;
whereby selective etching of the main surface (12) relative to the inclined surfaces (14) is achieved such that a recess (16) in the silicon nanostructure (10) is formed, the recess (16) having its opening at the main surface (12) of the silicon nanostructure (10).

2. The method according to claim 1, wherein the oxidizing (S210) is performed using plasma.

3. The method according to claim 1 or 2,
wherein the first etching process (S212) is performed by reactive ion etching with ions having a first kinetic energy upon impinging the silicon nanostructure (10), and
wherein the second etching process (S214) is performed by reactive ion etching with ions having a second kinetic energy upon impinging the silicon nanostructure (10), wherein the second kinetic energy is lower than the first kinetic energy.

4. The method according to claim 1 or 2,
wherein the first etching process (S212) is performed by reactive ion etching; and
wherein the second etching process (S214) is a second cyclic etching process, where each cycle comprises:
surface modification by introducing chemical species in a process chamber volume enclosing the silicon nanostructure (10), and
surface activation by noble gas ion bombardment.

5. The method according to claim 1 or 2,
wherein the first etching process (S212) is a third cyclic etching process, where each cycle comprises:
surface modification by introducing chemical species in a process chamber volume enclosing the silicon nanostructure (10), and
surface activation by noble gas ion bombardment having a third kinetic energy;
and
wherein the second etching process (S214) is a fourth cyclic etching process, where each cycle comprises:
surface modification by introducing chemical species in a process chamber volume enclosing the silicon nanostructure (10), and
surface activation by noble gas ion bombardment having a fourth kinetic energy, wherein the fourth kinetic energy is lower than the third kinetic energy.

6. The method according to claim 5, wherein the noble gas is argon for both the third cyclic etching process and the fourth cyclic etching process, wherein the fourth kinetic energy is an average kinetic energy of 40 eV to 60 eV, and wherein the third kinetic energy is an average kinetic energy in the range of 65 eV to 80 eV.

7. The method according to claim 1 or 2,
wherein the first etching process is a fifth cyclic etching process, where each cycle comprises:
surface modification, by introducing chemical species in a process chamber volume enclosing the silicon nanostructure (10), and
surface activation by noble gas ion bombardment; and
wherein the second etching process is performed by reactive ion etching.

8. The method according to any one of claims 1-7, wherein at least a portion, preferably each, of the cycles of the first cyclic process (S204) further comprises purging a process chamber volume used for the processing of the silicon nanostructure by flushing (S208) the process chamber volume with a gas mixture, preferably containing oxygen.

9. The method according to claim 8, wherein the flushing (S208) is performed for 1-30 seconds at 0.01-100 mTorr, preferably 0.1-3 mTorr, process pressure, and at 10-200 sccm, preferably 30-50 sccm, oxygen flow.

10. The method according to any one of claims 1-9, wherein the silicon nanostructure (10) is arranged on a support layer (20), wherein the support layer is preferably formed of silicon, silicon nitride, or silicon oxide.

11. The method according to any one of claims 3, 4 or 7, wherein the reactive ion etching is done using ionized SF₆ gas.

12. The method according to any one of claims 4, 5 or 7, wherein the surface modification is done in a gas phase that contains only neutral chemical species.

13. The method according to any one of claims 4, 5 or 7, wherein the surface modification is done by chemisorption of chlorine.

14. The method according to claims 4, 5 or 7, wherein the surface modification is followed by evacuating excessive chemical species from the process chamber volume.

15. The method according to claim 2, wherein the plasma in the oxidizing (210) is provided such that ions impinging the silicon nanostructure (10) have a kinetic energy below 1 eV, preferably below 0.1 eV.
